Europäisches Patentamt

European Patent Office

Office européen des brevets

(11) Numéro de publication: **0 288 859 B1**

## FASCICULE DE BREVET EUROPEEN

(45) Date de publication de fascicule du brevet: **10.06.92**   (51) Int. Cl.⁵: **H05K 7/14**

(21) Numéro de dépôt: **88106140.2**

(22) Date de dépôt: **18.04.88**

(54) **Dispositif de verrouillage d'un boîtier d'équipements électroniques sur un plateau.**

(30) Priorité: **22.04.87 FR 8705672**

(43) Date de publication de la demande:
**02.11.88 Bulletin 88/44**

(45) Mention de la délivrance du brevet:
**10.06.92 Bulletin 92/24**

(84) Etats contractants désignés:
**BE DE ES FR GB IT LU NL SE**

(56) Documents cités:
**EP-A- 0 071 559**
**FR-A- 2 229 611**
**US-A- 3 872 734**
**US-A- 4 506 439**

(73) Titulaire: **VIBRACHOC, Société Anonyme dite:**
**Parc d'Activités de l'Eglantier C.E. 2804 Lisses**
**F-91028 Evry Cédex(FR)**

(72) Inventeur: **Pavie, Denis**
**10, rue Saint Exupéry**
**F-91610 Ballancourt sur Essonne(FR)**

(74) Mandataire: **Weinmiller, Jürgen et al**
**Lennéstrasse 9 Postfach 24**
**W-8133 Feldafing(DE)**

## Description

La présente invention concerne un dispositif de verrouillage d'un boîtier d'équipements électroniques sur un plateau, comportant un chariot mobile relié à la face avant du boîtier, un axe fileté le long duquel se déplace le chariot, une chape logée sous le plateau et munie de deux lumières inclinées dans lesquelles se déplace une tige d'articulation fixée à une extrémité de l'axe fileté et perpendiculairement à celui-ci.

Ces boîtiers d'équipements électroniques sont placés sur des plateaux fixes, montés à demeure dans un engin, par exemple, dans le poste de pilotage d'un avion. Ils comportent à leur partie arrière, la partie femelle d'un connecteur comportant de multiples aiguilles de faible diamètre, donc relativement fragiles, qui s'engagent dans la partie mâle du connecteur montée à demeure à l'arrière du plateau.

La maintenance de ces engins oblige à remplacer de manière fréquente ces boîtiers et la mise en place ou le retrait de ceux-ci présentent des risques mécaniques importants pour les aiguilles du connecteur.

On connaît, notamment par le document FR-2 229 611, un dispositif de verrouillage dont l'axe central est muni à son extrémité d'une tige d'articulation se déplaçant dans une lumière inclinée, deux positions extrêmes permettant l'une de mettre en place le boîtier, donc d'enficher le connecteur, selon un angle aigu assurant une composante verticale qui plaque le boîtier sur le fond du plateau, et l'autre de retirer ce boîtier, donc d'extraire le connecteur parallèlement au fond du plateau.

Lorsque la tige est en appui à l'une ou l'autre extrémité de la lumière, cette tige n'est pas correctement immobilisée de sorte que le boîtier peut se soulever et ainsi endommager les aiguilles du connecteur arrière.

La présente invention a pour but d'assurer une immobilisation totale de la tige, lors de la mise en place ou du retrait du boîtier.

A cet effet, le dispositif de verrouillage de la présente invention est caractérisé en ce que chaque lumière comporte, à l'une et ou l'autre de ses extrémités, au moins une encoche d'arrêt dans laquelle vient s'immobiliser la tige d'articulation de l'axe fileté.

De préférence, chaque lumière comporte dans sa partie supérieure deux encoches qui permettent l'immobilisation de la tige d'articulation, l'axe étant alors immobilisé en position horizontale lors de la mise en place ou du retrait du boîtier, et, dans sa partie inférieure, une encoche qui assure l'immobilisation de la tige d'articulation, l'axe étant alors immobilisé en position inclinée assurant ainsi le maintien permanent du boîtier contre le fond du plateau.

Il est décrit, ci-après, à titre d'exemple et en référence aux dessins annexés, un dispositif de verrouillage selon l'invention.

- La figure 1 représente, en perspective, deux plateaux, l'un muni d'un boîtier et l'autre non, chaque plateau recevant deux dispositifs de verrouillage.
- La figure 2 montre la position d'un dispositif de verrouillage lors de la mise en place du boîtier.
- La figure 3 montre la position d'un dispositif de verrouillage permettant le maintien du boîtier après enfichage.
- La figure 4 montre la position d'un dispositif de verrouillage lors de l'extraction du boîtier.

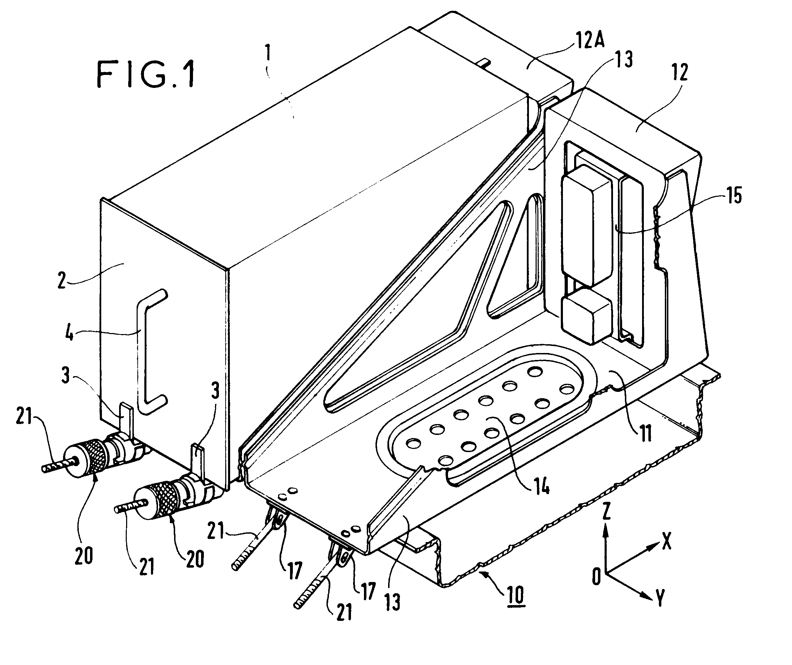

Dans la figure 1 sont représentés deux plateaux, l'un muni d'un boîtier et l'autre non, ceci permettant de bien montrer la constitution d'un plateau qui comporte un fond 11 muni d'un diaphragme 14 permettant une ventilation du boîtier, une plaque arrière 12 sur laquelle est montée la partie mâle 15 d'un connecteur, et enfin deux flancs latéraux 13 ajourés et de forme triangulaire.

A l'avant de ce plateau, et sous celui-ci, sont montées deux chapes 17 permettant chacune l'articulation d'un axe 21 du dispositif de verrouillage. Ce dispositif est relié mécaniquement à une patte 3 de la face avant 2 du boîtier 1, lors de l'enfichage, du maintien et de l'extraction du boîtier, l'enfichage et l'extraction s'opérant sur une distance très courte correspondant sensiblement à l'épaisseur du connecteur arrière. La préhension du boîtier, avant enfichage ou après extraction, se fait par l'intermédiaire d'une poignée 4 fixée sur la face avant 2 du boîtier.

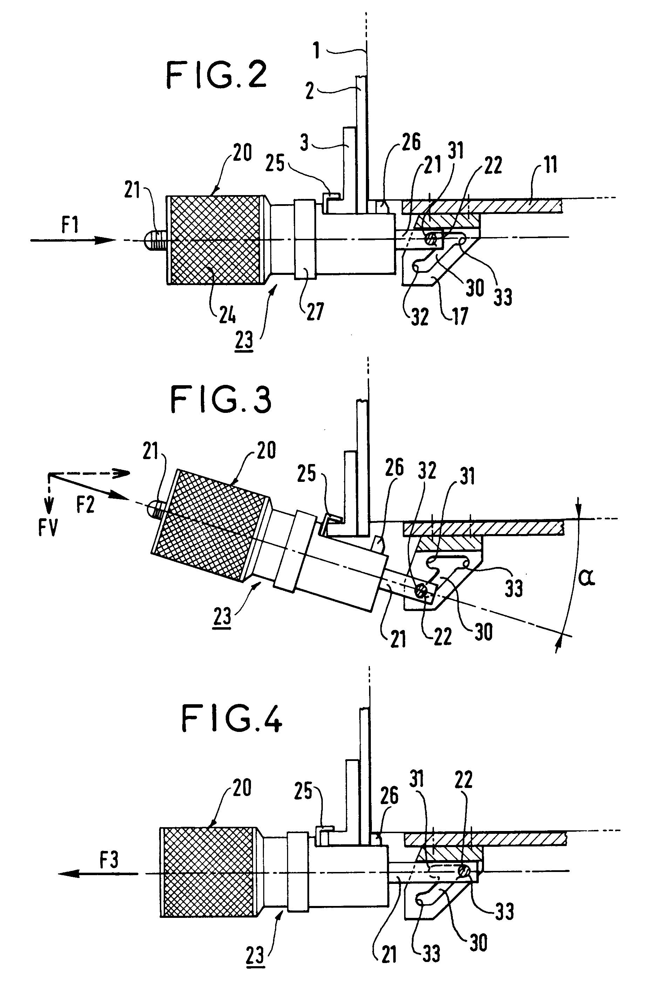

La figure 2 montre, en vue de côté, un dispositif de verrouillage 20 composé, de manière connue, d'un axe longitudinal 21 et d'un chariot 23 mobile par vissage le long de cet axe 21.

Ce chariot 23 comporte un bouton moleté 24 permettant le vissage ou le dévissage, donc la manoeuvre du chariot, un dispositif fixe 25 permettant l'accrochage du dispositif de verrouillage sur la patte 3 du boîtier, et un taquet arrière 26, escamotable par l'intermédiaire d'une bague 27, qui prend appui lors du retrait du boîtier, derrière la face 2 du boîtier (figure 3).

Bien entendu, le dispositif de verrouillage pourrait comporter, inversement, un dispositif d'accrochage escamotable et un taquet arrière fixe.

La figure 2, ainsi d'ailleurs que les figures 3 et 4, montre la forme particulière de la chape 17, fixée sous le fond 11 du plateau 10, et munie de deux lumières inclinées 30, chacune se terminant à son extrémité supérieure par deux encoches d'arrêt 31, 33, et à son extrémité inférieure par une encoche d'arrêt 32.

L'extrémité de l'axe 21 comporte, perpendiculairement à lui-même, une tige d'articulation 22, guidée entre les deux oreilles de la chape 17, qui se déplace dans chaque lumière 30 et qui prend apui, selon le cas, dans l'une ou l'autre des encoches d'arrêt 31, 32, 33.

Cette figure 2 montre le cas de la mise en place du boîtier. la tige d'articulation prend appui dans l'encoche d'arrêt 31 et le vissage du bouton moleté 24 provoque le déplacement du boîtier selon la flèche F1.

La figure 3 montre le cas du maintien du boîtier une fois l'enfichage réalisé. La tige d'articulation 22 prend appui dans l'encoche d'arrêt 32 et le verrou, ainsi incliné selon un angle α, induit une composante verticale Fv qui s'oppose au soulèvement du boîtier lorsque celui-ci est installé dans un engin en service.

La figure 4 montre le cas du retrait du boîtier. La tige 22 prend appui dans l'encoche d'arrêt 33, le taquet 26 s'appuie derrière la face 2, et le dévissage du bouton moleté 24 provoque ainsi le déplacement du boîtier selon la flèche F3.

Une opération de mise en place d'un boîtier s'effectue de la manière suivante :

L'opérateur maintient le boîtier par sa poignée 4, pose celui-ci sur le plateau et le pousse jusqu'à ce que la partie femelle du connecteur vienne au contact de la partie mâle 15. Il accroche ensuite chaque dispositif de verrouillage sur la patte 3 correspondante, et visse les boutons moletés ce qui provoque un déplacement du boîtier selon l'axe OX₊ jusqu'à ce que le connecteur soit correctement enfiché. Il dévisse ensuite ces boutons moletés, incline les dispositifs de verrouillage en amenant chaque tige d'articulation dans les encoches 32 puis revisse les boutons moletés pour bloquer le boîtier. La mise en place est ainsi terminée.

Une opération de retrait d'un boîtier s'effectue de la manière suivante :

L'opérateur dévisse les boutons moletés, redresse les dispositifs de verrouillage, met en place les taquets 26 en tournant la bague 27, et enfin amène chaque tige d'articulation dans les encoches 33.

Il dévisse les boutons moletés jusqu'à ce que le connecteur arrière soit déconnecté, puis il prend le boîtier par la poignée 4 et l'enlève du plateau 11.

## Revendications

1. Dispositif de verrouillage d'un boîtier (1) d'équipements électroniques sur un plateau (11), comportant un chariot mobile (20) relié à la face avant (2) du boîtier (1), un axe fileté (21) le long duquel se déplace le chariot, une chape (17) logée sous le plateau et munie de deux lumières (30) inclinées dans lesquelles se déplace une tige d'articulation (22) fixée à une extrémité de l'axe fileté (21) et perpendiculairement à celui-ci, caractérisé en ce que chaque lumière (30) comporte, à l'une et/ou l'autre de ses extrémités, au moins une encoche d'arrêt (31, 32, 33) dans laquelle vient s'immobiliser la tige d'articulation (22) de l'axe fileté (21).

2. Dispositif de verrouillage selon la revendication 1, caractérisé en ce que chaque lumière (30) comporte, à sa partie supérieure, une encoche d'arrêt (31) assurant une immobilisation de la tige d'articulation (22), l'axe (21) étant alors immobilisé en position horizontale lors de la mise en place du boîtier.

3. Dispositif de verrouillage selon la revendication 1, caractérisé en ce que chaque lumière (30) comporte, à sa partie supérieure, une encoche d'arrêt (33) assurant une immobilisation de la tige d'articulation (22), l'axe (21) étant alors immobilisé en position horizontale lors du retrait du boîtier.

4. Dispositif de verrouillage selon la revendication 1, caractérisé en ce que chaque lumière (30) comporte, à sa partie inférieure, une encoche d'arrêt (32) assurant une immobilisation de la tige d'articulation (22), l'axe (21) étant alors en position inclinée assurant un maintien permanent du boîtier contre le fond (11) du plateau (10).

## Claims

1. A device for locking an electronic equipment housing (1) on a tray (11), the device comprising a moving carriage (20) connected to the front face (2) of the housing (1), a threaded shaft (21) along which the carriage moves, and a hinge (17) disposed beneath the tray and provided with two inclined slots (30) in which a hinge pin (22) moves which is fixed perpendicularly to one of the ends of the threaded shaft (21), characterized in that each slot (30) includes at one and/or the other of its ends at least one stop notch (31, 32, 33) in which the hinge pin (22) of the threaded shaft (21) is immobilized.

2. A locking device according to claim 1, characterized in that each slot (30) comprises at the top end a stop notch (31) for immobilizing the hinge pin (22), with the shaft (21) being held fast in a horizontal position when the housing is being installed.

3. A locking device according to claim 1, characterized in that each slot (30) comprises at the top end a stop notch (33) for immobilizing the hinge pin (22), with the shaft (21) being held fast in a horizontal position when the housing is being removed.

4. A locking device according to claim 1, characterized in that each slot (30) comprises at the bottom end a stop notch (32) for immobilizing the hinge pin (22), when the shaft (21) is in an inclined position for permanently pressing the housing against the bottom (11) of the tray (10).

**Patentansprüche**

1. Vorrichtung zur Verriegelung eines Gehäuses (1) mit elektronischen Anlagen auf einer Platte (11), wobei die Vorrichtung einen mit der Vorderfläche (2) des Gehäuses verbundenen beweglichen Wagen (20), eine Gewindespindel (21), entlang deren sich der Wagen verschiebt, eine Lasche (17), die unter der Platte angeordnet und mit zwei schrägen Schlitzlöchern (30) versehen ist, in denen sich ein Gelenkstift (22) verschiebt, der mit einem Ende der Gewindespindel (21) senkrecht zu ihr verbunden ist, dadurch gekennzeichnet, daß jede Schlitzöffnung (30) an einem und/oder am anderen ihrer Enden mindestens eine Anschlagnut (31, 32 33) aufweist, in welcher sich der Gelenkstift (22) der Gewindespindel (21) blockiert.

2. Verriegelungsvorrichtung nach Anspruch 1, dadurch gekennzeichnet, daß jede Schlitzöffnung (30) in ihrem oberen Abschnitt eine Anschlagnut (31) aufweist, die eine Blockierung des Gelenkstifts (22) bewirkt, so daß die Spindel (21) in waagrechter Stellung während des Einsetzens des Gehäuses blokkiert wird.

3. Verriegelungsvorrichtung nach Anspruch 1, dadurch gekennzeichnet, daß jede Schlitzöffnung (30) in ihrem oberen Abschnitt eine Anschlagnut (33) aufweist, die eine Blockierung des Gelenkstifts (22) bewirkt, so daß die Spindel (21) in der waagrechten Stellung während des Herausziehens des Gehäuses blockiert wird.

4. Verriegelungsvorrichtung nach Anspruch 1, dadurch gekennzeichnet, daß jede Schlitzöffnung (30) in ihrem unteren Abschnitt eine Anschlagnut (31) aufweist, die eine Blockierung des Gelenkstifts (22) bewirkt, wobei sich die Spindel (21) in Schrägstellung befindet und eine dauernde Halterung des Gehäuses gegen den Boden (11) der Platte (10) bewirkt.

FIG.1

# FIG.2

F1

20  21  25  3  26  31  21  22  11
24  23  27  32  17  30  33

# FIG.3

FV
F2  21  20  25  26  32  31
23  21  22  30  33  α

# FIG.4

F3  20  25  26  31  22
23  21  33  33  30